# EUROPÄISCHE PATENTSCHRIFT

(11) **EP 1 619 730 B1**
(45) Veröffentlichungstag und Bekanntmachung des Hinweises auf die Patenterteilung: **07.07.2010**
(21) Anmeldenummer: 04017194.4
(22) Anmeldetag: 21.07.2004
(51) Int. Cl.: H01L 41/053

(54) **Verfahren zum Verbessern der Langzeitstabilität eines piezoelektrischen Aktors und piezoelektrischer Aktor**
Method for improving long-time stability of a piezoelectric actuator and piezoelectric actuator
Méthode pour améliorer la stabilité de longue durée d'un actionneur piézo-électrique et actionneur piézo-électrique

(43) Veröffentlichungstag der Anmeldung: 25.01.2006
(60) Teilanmeldung: 10005054.1
(73) Patentinhaber: Continental Automotive GmbH, 30165 Hannover (DE)
(72) Erfinder: Denzler, Michael, 93055 Regensburg (DE); Kohn, Stefan, 92277 Hohenburg (DE); Neumaier, Martin, Dr., 93059 Regensburg (DE); Niefanger, Roland, 93055 Regensburg (DE); Plecher, Klaus, 93197 Zeitlarn (DE); Voigt, Andreas, Dr., 93133 Burglengenfeld (DE); Zumstrull, Claus, 93128 Regenstauf (DE)

(56) Entgegenhaltungen:
- DE-A- 10 244 614
- DE-A- 19 818 036
- US-A- 5 295 288
- PATENT ABSTRACTS OF JAPAN Bd. 1995, Nr. 06, 31. Juli 1995 (1995-07-31) -& JP 07 086654 A (NIKON CORP), 31. März 1995 (1995-03-31)

## Beschreibung

Die Erfindung betrifft ein Verfahren zum Verbessern der Langzeitstabilität eines piezoelektrischen Aktors gemäß Patentanspruch 1.

Piezoelektrische Aktoren werden in den verschiedensten technischen Bereichen eingesetzt, um eine schnelle und präzise Betätigung eines Stellglieds erreichen zu können. Ein bevorzugter Einsatz der piezoelektrischen Aktoren ist beispielsweise in der Kraftfahrzeugtechnik in einem Einspritzventil, in dem der piezoelektrische Aktor die Einspritzung steuert. Dabei wird vorzugsweise die hohe Dynamik und schnelle Steuerbarkeit des piezoelektrischen Aktors eingesetzt.

Piezoelektrische Aktoren weisen wenigstens ein piezoelektrisches Element auf, das zwischen zwei Elektroden angeordnet ist. Durch ein Anlegen einer Spannung an die zwei Elektroden wird die Dicke des piezoelektrischen Elements verändert und somit eine Betätigung eines Stellglieds ermöglicht. Da jedoch die Längung oder Verkürzung des piezoelektrischen Aktors in Abhängigkeit von der angelegten Spannung relativ klein ist, wird bei Einspritzventilen als piezoelektrischer Aktor ein Stapel von einer Vielzahl von piezoelektrischen Elementen eingesetzt, die jeweils zwischen zwei Elektroden angeordnet sind. Die Elektroden sind vorteilhaft über Drähte mit zwei Kontaktstiften elektrisch leitend verbunden. Der Stapel, die Drähte und die Kontaktstifte werden beispielsweise in eine entsprechende Ausnehmung eines zylinderförmigen Kunststoffgehäuses eingebracht. Anschließend wird die Ausnehmung mit einer Vergussmasse aufgefüllt. Damit wird der Stapel mit der Vergussmasse umhüllt und gegen Umwelteinflüsse geschützt. Zudem sind die Elektroden, die einen geringen Abstand voneinander haben, elektrisch isoliert. Weiterhin wird dadurch eine feste Halterung des Stapels in dem Kunststoffgehäuse erreicht. Die Vergussmasse besteht beispielsweise aus Silikon.

Entsprechende piezoelektrische Aktoren sind beispielsweise aus der Patentanmeldung DE 102 29 494 A1 oder aus der Patentschrift DE 198 44 742 C1 bekannt.

Aus DE 198 18 036 A1 ist ein Verfahren zur Herstellung eines elektrotechnischen Bauteils mit einer Kunststoff passivierten Oberfläche bekannt. Das elektrotechnische Bauteil stellt einen piezoelektrischen Aktor dar, der eine piezoelektrische Keramik aufweist. Die Keramik wird in einen hülsenförmigen Kunststoffkörper eingebracht und anschließend der Zwischenraum zwischen dem Kunststoffkörper und der piezoelektrischen Keramik mit einem Kunststoff ausgegossen.

Aus US 5,295,288 ist ein Verfahren zur Herstellung eines piezoelektrischen Aktors und ein piezoelektrischer Aktor bekannt. Der piezoelektrische Aktor ist in ein Gehäuse eingebracht, wobei der Zwischenraum zwischen dem Gehäuse und dem piezoelektrischen Aktor mit einer Silikonfüllung ausgefüllt ist. Die Silikonfüllung wird in einem ersten Verfahrensschritt mit einer ersten Temperatur ausgeheizt und anschließend in einem zweiten Verfahrensschritt mit einer zweiten Temperatur ausgehärtet, um eine haftende Verbindung zwischen dem Silikon und dem piezoelektrischen Element herzustellen. Die erste Temperatur liegt bei 1180°C und der erste Verfahrensschritt dauert ungefähr zwei Stunden. Die zweite Temperatur liegt bei 145°C bis 150°C und der zweite Verfahrensschritt dauert vier Stunden.

Aus JP 07086654 A ist ein piezoelektrischer Aktor bekannt, der aus einer Vielzahl von piezokeramischen Schichten mit Elektroden besteht. Der piezoelektrische Aktor ist mit einer Vergussmasse umhüllt.

Aus DE 102 44 614 A ist ein Einspritzventil mit einer Flüssigkeitskühlung und einem Verfahren zum Befüllen des Einspritzventils bekannt. Das Einspritzventil weist einen piezoelektrischen Aktor auf, der in dem Gehäuse des Einspritzventils angeordnet ist. Ein Zwischenraum zwischen dem Gehäuse und dem piezoelektrischen Aktor ist mit einer inerten, elektrisch nicht leitenden und gut wärmeleitenden Flüssigkeit gefüllt.

Die Aufgabe der Erfindung besteht darin, ein Verfahren und einen piezoelektrischen Aktor bereitzustellen, der eine erhöhte Langzeitstabilität aufweist.

Die Aufgabe der Erfindung wird durch das Verfahren gemäß Patenanspruch 1 und durch den piezoelektrischen Aktor gemäß Patentanspruch 7 gelöst.

Vorteilhafte Ausführungsformen der Erfindung sind in den abhängigen Ansprüchen angegeben.

Ein Vorteil der Erfindung besteht darin, dass die chemische Reaktion zwischen dem reduzierenden Stoff der Vergussmasse und der piezoelektrischen Keramik vermindert oder sogar vermieden wird.

In einer weiteren Ausführungsform besteht ein Vorteil des erfindungsgemäßen Verfahrens darin, dass die Reaktionshäufigkeit zwischen dem Sauerstoff der Keramik und einem reduzierenden Stoff der Vergussmasse gesenkt wird. Versuche haben gezeigt, dass verwendete Vergussmassen eine reduzierende Atmosphäre schaffen, die mit dem Sauerstoff der Keramik reagiert und den Sauerstoff aus der Keramik löst. Bei der Verwendung einer Vergussmasse, die beispielsweise Wasserstoff enthält, sind nicht alle Wasserstoffatome vollständig gebunden, sondern weisen freie Bindungen auf. Der Wasserstoff versucht, chemische Bindungen einzugehen. Dabei bietet sich der Sauerstoff der piezoelektrischen Keramik an. Durch den chemischen Ausbau der in der Piezokeramik gebundenen Sauerstoffatome nimmt die Sauerstoff-Leerstellenleitung zu. Dies führt dazu, dass die elektrische Leitfähigkeit der piezoelektrischen Keramik erhöht wird. Dies wiederum führt zu mechanischen Rissen und elektrischen Spannungsüberschlägen zwischen den Elektroden der piezoelektrischen Elemente. Damit wird insgesamt die Langzeitstabilität des piezoelektrischen Aktors reduziert. Durch die erfindungsgemäßen Maßnahmen wird die Reaktionshäufigkeit des reduzierenden Stoffes, beispielsweise des Wasserstoffs der Vergussmasse mit dem Sauerstoff der piezoelektrischen Keramik vermindert. Auf diese Weise wird die Qualität des piezoelektrischen Aktors erhöht.

Bei dem erfindungsgemäßen Verfahren wird eine Vergussmasse verwendet, in der ein chemisch reduzierender Stoff nur mit einer vorgegebenen maximalen Konzentration enthalten ist. Erfindungsgemäß wird eine Vergussmasse mit einem Haftvermittler verwendet, der eine Konzentration von weniger als 1 Gewichtsprozent aufweist. Diese Konzentration ist ausreichend für die Funktion als Haftvermittler und bildet zudem kaum ein Angebot eines Stoffes, der mit dem Sauerstoff der Keramik chemische Bindungen eingeht.

Vorzugsweise wird eine Vergussmasse verwendet, die als reduzierenden Stoff Wasserstoff in Form von Silan enthält, wobei jedoch die Konzentration von Silan kleiner als 1 Gewichtsprozent ist. Aufgrund der geringen Konzentration von Silan und damit der geringen Konzentration von Wasserstoff wird die Reaktionshäufigkeit zwischen dem Sauerstoff der piezoelektrischen Keramik und dem Wasserstoff deutlich gesenkt. Silan hat in der Vergussmasse die Aufgabe eines Haftvermittlers, so dass die Haftfähigkeit zwischen der Oberfläche der piezoelektrischen Keramik und der verwendeten Vergussmasse, die beispielsweise Silikon aufweist, erhöht wird. Für eine ausreichende Haftvermittlung zwischen der Oberfläche der piezoelektrischen Keramik und dem Silikon ist eine gewisse Mindestmenge von Silan erforderlich. Jedoch führt ein Überangebot von Silan dazu, dass Wasserstoff mit chemisch freien Bindungen in der Vergussmasse vorhanden ist. Da sich der Haftvermittler an der Oberfläche der Keramik absetzt, besteht die Gefahr, dass die ungesättigten Bindungen des Wasserstoffs mit dem Sauerstoff der piezoelektrischen Keramik chemische Bindungen eingehen. Durch die Reduzierung der Konzentration der Wasserstoffatome und insbesondere durch die Reduzierung der Konzentration von Silan wird der Auslösevorgang von Sauerstoff aus der piezoelektrischen Keramik abgeschwächt.

In einer weiteren Ausführungsform des Verfahrens wird nach Umgießen des piezoelektrischen Aktors mit der Vergussmasse durch einen Wärmeprozess die Konzentration des reduzierenden Stoffes und/oder die Konzentration der Reaktionspartner, die den reduzierenden Stoff bilden, in der Vergussmasse gesenkt. Damit wird die Menge des für eine Reaktion mit dem Sauerstoff der piezoelektrischen Keramik zur Verfügung stehenden reduzierenden Stoffs verkleinert. Somit können weniger Sauerstoffatome der piezoelektrischen Keramik mit dem reduzierenden Stoff der Vergussmasse chemische Bindungen eingehen.

Vorzugsweise wird die Konzentration des reduzierenden Stoffs, insbesondere Wasserstoff mit dem Wärmeprozess unter eine vorgegebene Schwelle abgesenkt. Somit wird eine vorgegebene Qualität des piezoelektrischen Aktors eingestellt, die eine erhöhte Langzeitstabilität bewirkt.

In einer weiteren bevorzugten Ausführungsform wird der piezoelektrische Aktor in ein Gehäuse, insbesondere in ein Gehäuse eines Einspritzventils eingebaut, in dem Mittel zum Zuführen von Sauerstoff zur Vergussmasse vorgesehen sind. Durch das Anbieten von freiem Sauerstoff wird die Reaktionshäufigkeit der ungesättigten Bindungen des reduzierenden Stoffs, insbesondere des Wasserstoffs der Vergussmasse mit dem Sauerstoff der piezoelektrischen Keramik reduziert. Zudem kann eine Membran eingesetzt werden, um Sauerstoff in das Gehäuse einzuführen.

In einer weiteren bevorzugten Ausführungsform weist das Gehäuse Mittel zum Abführen des reduzierenden Stoffs, insbesondere von Wasserstoff auf. Das Mittel kann beispielsweise in Form einer Membran ausgebildet sein, das ein Entweichen des reduzierenden Stoffs aus dem Gehäuse ermöglicht.

In einer weiteren Ausführungsform des Verfahrens ist im Gehäuse ein zweiter Stoff vorgesehen, der bestrebt ist, Bindungen mit dem reduzierenden Stoff der Vergussmasse einzugehen. Auch auf diese Weise werden die freien Bindungen des reduzierenden Stoffs der Vergussmasse belegt, so dass eine Reaktion des reduzierenden Stoffs mit dem Sauerstoff der piezoelektrischen Keramik verhindert wird.

Ein Einspritzventil mit erfindungsgemäßem Aktor weist den Vorteil auf, dass die Langzeitstabilität der piezoelektrischen Keramik verbessert ist. Dies wird erfindungsgemäß dadurch erreicht, dass Mittel vorgesehen sind, mit denen Stoffe, die mit Sauerstoff chemische Bindungen eingehen, abgeführt und/oder Sauerstoff zugeführt werden kann.

Die Erfindung wird im folgenden anhand der Figuren näher erläutert. Es zeigen
Figur 1 eine schematische Darstellung eines piezoelektrischen Aktors, der über eine Vergussmasse in einer Kunststoffhülse befestigt ist, und
Figur 2 einen Teilausschnitt eines Einspritzventils mit einem Gehäuse, in dem der piezoelektrische Aktor eingebracht ist.

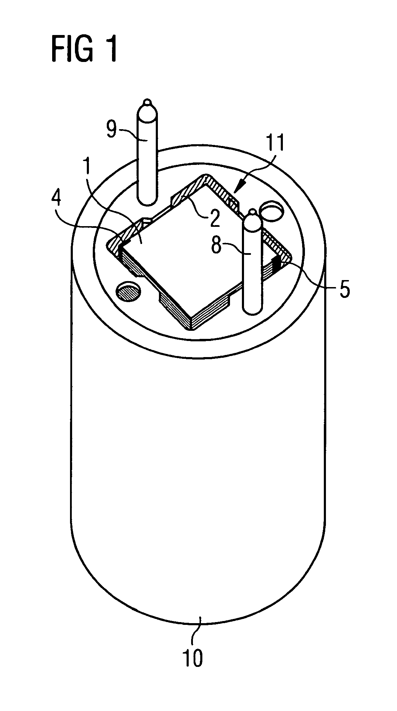

Figur 1 zeigt in einer perspektivischen Darstellung einen piezoelektrischen Aktor 1, der aus einem Stapel von piezoelektrischen Elementen aufgebaut ist, wobei jedes piezoelektrische Element zwischen zwei Elektroden angeordnet ist. Die Elektroden sind abwechselnd zu einem ersten oder zweiten Leiterstreifen 4, 5 geführt, die an gegenüberliegenden Eckbereichen des quadratisch geformten piezoelektrischen Aktors 1 angeordnet sind. Der erste und der zweite Leiterstreifen 4, 5 sind über Leiterfolien an Kontaktstifte 8, 9 angeschlossen. Auf diese Weise ist der erste Kontaktstift 8 elektrisch leitend mit einer ersten Hälfte der Elektroden 3 verbunden. Der zweite Kontaktstift 9 ist mit der anderen Hälfte der Elektroden 3 elektrisch leitend verbunden. Der vormontierte piezoelektrische Aktor 1 mit den Leiterfolien und den Kontaktstiften 8, 9 wird in eine Kunststoffhülse 10 eingebracht, die eine entsprechende Ausnehmung 11 aufweist. Anschließend wird die Ausnehmung 11 mit einer Vergussmasse 2 aufgefüllt, so dass eine Halterung des piezoelektrischen Aktors 1 in der Kunststoffhülse 10 erreicht wird. Die Vergussmasse 2 besteht beispielsweise aus Silikon. Die piezoelektrischen Elemente bestehen aus einer piezoelektrischen Keramik, die Sauerstoff enthält.

Die Vergussmasse 2 wird dazu verwendet, um den piezoelektrischen Aktor 1 dicht zu ummanteln, so dass weder Feuchtigkeit, noch Kraftstoff oder Öl an die piezoelektrischen Elemente gelangen können. Zudem dient die Vergussmasse 2 zur elektrischen Isolierung der Elektroden und zur Abführung von Wärme. In Abhängigkeit von der verwendeten Ausführungsform kann auch auf die Kunststoffhülse 10 verzichtet werden.

Gemäß der Erfindung wird eine Vergussmasse 2 verwendet, die einen chemisch reduzierenden Stoff enthält, der bestrebt ist, chemische Bindungen mit dem Sauerstoff der piezoelektrischen Keramik einzugehen. Beispielsweise wird eine Vergussmasse verwendet, die einen reduzierenden Stoff bildet. Beispielsweise kann eine reduzierende Gasatmosphäre durch ein Aushärten oder Nebenreaktionen der Vergussmasse gebildet werden. Beispielsweise wird eine Vergussmasse verwendet, die einen Haftver- mittler in Form von Silan und damit Wasserstoff enthält. Gemäß der Erfindung ist die Konzentration von Silan kleiner als 1 Gewichtsprozent. Somit ist relativ wenig Wasserstoff in der Vergussmasse 2 enthalten, so dass die Reaktionshäufigkeit zwischen dem Sauerstoff der piezoelektrischen Elemente und dem Wasserstoff der Vergussmasse 11 reduziert ist. Es können jedoch auch Vergussmassen 2 mit anderen reduzierenden Stoffen verwendet werden, deren Konzentrationen entsprechend niedrig gehalten ist.

In Abhängigkeit von der verwendeten Vergussmasse wird eine möglichst geringe Konzentration an Wasserstoff verwendet. Bei der Verwendung eines Haftvermittlers in der Vergussmasse 11 werden vorzugsweise Konzentrationen zwischen 0,5 und 0,25 Gewichtsprozent des Haftvermittlers verwendet. Diese Konzentrationen werden auch bevorzugt bei Silan als Haftvermittler verwendet.

In einer weiteren vorteilhaften Ausführungsform wird nach dem Vergießen des piezoelektrischen Aktors 1 in der Kunststoffhülse 10 ein Wärmeprozess mit erhöhter Temperatur durchgeführt. Der Wärmeprozess wird vorzugsweise so lange durchgeführt, bis nur noch eine vorgegebene Konzentration des reduzierenden Stoffes, in diesem Fall Wasserstoff in der Vergussmasse vorliegt. In einer weiteren Ausführungsform kann auch die Konzentration der Reaktionspartner, die den reduzierenden Stoff bilden, durch den Wärmeprozess reduziert werden. Die einzustellende Konzentrationen von Wasserstoff wird zuvor experimentell ermittelt. Für die Durchführung des Wärmeprozesses werden Temperaturen von über 120° C eingesetzt. Vorzugsweise wird während des Wärmeprozesses der Druck abgesenkt auf Werte von bis zu 2-3 mbar. Für die Durchführung des Wärmeprozesses eignet sich die Verwendung einer Niederdruckkammer, in der der umgossene piezoelektrische Aktor 1 angeordnet ist.

In einer weiteren bevorzugten Ausführungsform weist die Vergussmasse einen zweiten Stoff auf, der mit dem reduzierenden Stoff der Vergussmasse chemische Bindungen eingeht. Vorzugsweise enthält der zweite Stoff Sauerstoff für eine Reaktion mit ungesättigten Bindungen des reduzierenden Stoffes, insbesondere mit Wasserstoff der Vergussmasse.

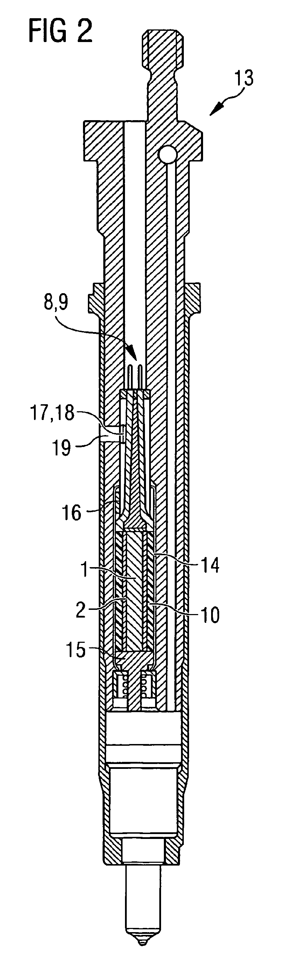

Figur 2 zeigt einen Teilausschnitt eines Einspritzventils 13 mit einem Gehäuse 14, in dem der piezoelektrische Aktor 1 in der Kunststoffhülse 10 eingebaut ist und in Wirkverbindung mit einem Stellglied 15 steht. In Abhängigkeit von der Bestromung des piezoelektrischen Aktors 1 wird die Position des Stellglieds 15 von dem piezoelektrischen Aktor 1 verändert. Das Stellglied 15 kann beispielsweise in Form eines Servoventils oder in Form einer Einspritznadel ausgebildet sein. Vorzugsweise ist im Gehäuse der zweite Stoff 16 angeordnet, der beispielsweise Sauerstoff für eine Reaktion mit ungesättigten Bindungen des Wasserstoffs der Vergussmasse 2 bereitstellt.

In einer weiteren bevorzugten Ausführungsform weist das Gehäuse 14 ein Öffnung 17 auf, in der eine Membran 18 angeordnet ist. Die Öffnung 17 ist an einen Kanal 19 angeschlossen. Die Membran 18 weist in einer ersten Ausführungsform die Eigenschaft auf, den reduzierenden Stoff, insbesondere Wasserstoff aus dem Gehäuse 14 entweichen zu lassen. In einer zweiten Ausführungsform weist die Membran 18 die Eigenschaft auf, einen reduzierbaren Stoff, insbesondere Sauerstoff aus dem Kanal 19 in das Gehäuse 14 eindringen zu lassen. In Abhängigkeit von der Umgebung des Gehäuses 14 wird die Membran 18 gasdurchlässig, öldicht und wasserdicht ausgebildet. Auf diese Weise ist ein Zuführen von Sauerstoff in das Gehäuse 14 möglich, ohne dass Öl oder Feuchtigkeit in das Gehäuse 14 eindringt.

Durch die erfindungsgemäße Lehre wird die Menge des aus der piezoelektrischen Keramik gelösten Sauerstoffs reduziert, so dass die Langzeitstabilität des piezoelektrischen Aktors erhöht wird.

## Patentansprüche

1. Verfahren zum Verbessern der Langzeitstabilität eines mit einer Vergussmasse (2) umgebenen piezoelektrischen Aktors (1), wobei die Vergussmasse (2) einen chemisch reduzierenden Stoff, der mit Sauerstoff chemische Bindungen eingeht, insbesondere Wasserstoff enthält oder bildet und an der Oberfläche des piezoelektrischen Aktors (1) anliegt, wobei der piezoelektrische Aktor (1) aus einer piezoelektrischen Keramik besteht, die Sauerstoff enthält, wobei eine Vergussmasse verwendet wird, die einen Haftvermittler, insbesondere Silan aufweist, wobei der Haftvermittler den reduzierenden Stoff aufweist oder bildet, **dadurch gekennzeichnet, dass** Mittel verwendet werden, mit denen eine Wechselwirkung zwischen der Vergussmasse oder dem reduzierenden Stoff und dem Sauerstoff der Keramik erschwert oder unterbunden wird, dass als reduzierender Stoff Wasserstoff in der Vergussmasse vorgesehen wird, dass die Konzentration des Haftvermittlers kleiner als 1 Gewichtsprozent ist, so dass die Reaktionshäufigkeit zwischen dem Wasserstoff der Vergussmasse und dem Sauerstoff der Keramik gesenkt wird.

2. Verfahren nach Anspruch 1, **dadurch gekennzeichnet, dass** die Konzentration des reduzierenden Stoffes und/oder die den reduzierenden Stoff bildenden Reaktionspartner in der Vergussmasse durch einen Wärmeprozess mit erhöhter Temperatur reduziert wird.

3. Verfahren nach Anspruch 2, **dadurch gekennzeichnet, dass** der Wärmeprozess so durchgeführt wird, dass die Konzentration des reduzierenden Stoffes, insbesondere von Wasserstoffs unter eine vorgegebene Schwelle sinkt.

4. Verfahren nach einem der Ansprüche 1 bis 3, **dadurch gekennzeichnet, dass** der Aktor (1) in ein Gehäuse (14) eingebaut wird, und dass das Gehäuse (14) Mittel (17, 18, 19) zum Zuführen von Sauerstoff zur Vergussmasse (2) aufweist.

5. Verfahren nach einem der Ansprüche 1 bis 4, **dadurch gekennzeichnet, dass** der Aktor in ein Gehäuse (14) eingebaut wird, und dass das Gehäuse (14) Mittel (17, 18, 19) zum Abführen des reduzierenden Stoffes aufweist, der von der Vergussmasse freigesetzt wird.

6. Verfahren nach einem der Ansprüche 1 bis 5, **dadurch gekennzeichnet, dass** der Aktor in ein Gehäuse eingebaut wird, und dass im Gehäuse ein Stoff (16) enthalten ist, der bestrebt ist, Bindungen mit dem chemisch reduzierenden Stoff der Vergussmasse (2) einzugehen.

7. Piezoelektrischer Aktor (1) mit einer piezoelektrischen Keramik, die mit einer Vergussmasse (2) umgeben ist, wobei die Vergussmasse (2) einen chemisch reduzierenden Stoff, der mit Sauerstoff chemische Bindungen eingeht, insbesondere Wasserstoff enthält, wobei die Vergussmasse (2) einen Haftvermittler aufweist, **dadurch gekennzeichnet, dass** die Konzentration des Haftvermittlers kleiner als 1 Gewichtsprozent ist.

8. Piezoelektrischer Aktor nach Anspruch 7, **dadurch gekennzeichnet, dass** der Aktor in ein Gehäuse (14) eingebaut ist, und dass im Gehäuse ein Stoff (16) vorgesehen ist, der die Reaktionsfreudigkeit zwischen dem reduzierenden Stoff und dem in der Keramik enthaltenen Sauerstoff absenkt.

9. Piezoelektrischer Aktor nach Anspruch 7 oder 8, **dadurch gekennzeichnet, dass** das Gehäuse (14) Mittel (17, 18, 19) zum Zuführen von Stoffen aufweist, die mit dem reduzierenden Stoff der Vergussmasse (2) chemische Bindungen eingehen.

10. Piezoelektrischer Aktor nach Anspruch 7, 8 oder 9, **dadurch gekennzeichnet, dass** Mittel (17, 18, 19) zum Abführen des reduzierenden Stoffs aus dem Gehäuse (14) und/oder Mittel (17, 18, 19) zum Zuführen von Stoffen vorgesehen sind, die mit dem reduzierenden Stoff der Vergussmasse (2) chemische Bindungen eingehen.

11. Piezoelektrischer Aktor nach Anspruch 9 oder 10, **dadurch gekennzeichnet, dass** die Mittel (17, 18, 19) als Membran im Gehäuse (14) ausgebildet sind, durch die die entsprechenden Stoffe entweichen und/oder zugeführt werden können.

## Claims

1. Method for improving the long-term stability of a piezoelectric actuator (1) encased in a potting compound (2), with said potting compound (2) containing or forming a chemically reductive substance, which establish chemical bonds with oxygen, in particular hydrogen, and being applied against the surface of said piezoelectric actuator (1), with said piezoelectric actuator (1) consisting of a piezoelectric ceramic containing oxygen, wherein a potting compound is used having a bonding agent, in particular hydrosilicon, with the bonding agent having or forming the reductive substance, **characterised in that** means are employed by which reciprocal action between the potting compound or the reductive substance and the oxygen in the ceramic is impeded or prevented, that hydrogen is provided as the reductive substance in the potting compound and **in that** bonding agent's concentration is less than 1 percent in weight so that the frequency of reaction between the hydrogen in the potting compound and the oxygen in the ceramic is reduced.

2. Method according to claim 1, **characterised in that** the concentration of the reductive substance and/or the reaction partners forming the reductive substance in the potting compound is reduced by means of a thermal process applied at a raised temperature.

3. Method according to claim 2 **characterised in that** the thermal process is applied in such a way that the concentration of the reductive substance, in particular hydrogen, will fall to below a predefined threshold.

4. Method according to one of claims 1 to 3 **characterised in that** the actuator (1) is installed in a housing (14) and **in that** said housing (14) has means (17, 18, 19) for ducting oxygen to the potting compound (2).

5. Method according to one of claims 1 to 4 **characterised in that** the actuator is installed in a housing (14) and **in that** said housing (14) has means (17, 18, 19) for dissipating the reductive substance released from the potting compound.

6. Method according to one of claims 1 to 5 **characterised in that** the actuator is installed in a housing and **in that** said housing contains a substance (16) avid to establish bonds with the chemically reductive substance in the potting compound (2).

7. Piezoelectric actuator (1) having a piezoelectric ceramic encased in a potting compound (2), with said potting compound (2) containing a chemically reductive substance, which establishes chemical bonds with oxygen, in particular hydrogen, with the potting compound (2) having a bonding agent, **characterised in that** the bonding agent's concentration is less than 1 percent in weight.

8. Piezoelectric actuator according to claim 7 **characterised in that** said actuator is installed in a housing (14) and **in that** a substance (16) is provided in said housing that will reduce the avidity between the reductive substance and the oxygen contained in the ceramic.

9. Piezoelectric actuator according to claim 7 or 8, **characterised in that** the housing (14) has means (17, 18, 19) for ducting substances that establish chemical bonds with the reductive substance in the potting compound (2).

10. Piezoelectric actuator according to claim 7, 8, or 9 **characterised in that** means (17, 18, 19) for removing the reductive substance from the housing (14) and/or means (17, 18, 19) for ducting substances that establish chemical bonds with the reductive substance in the potting compound (2) are provided.

11. Piezoelectric actuator according to claim 9 or 10, **characterised in that** the means (17, 18, 19) are embodied as a membrane in the housing (14) through which membrane the corresponding substances are able to escape and/or be ducted.

## Revendications

1. Procédé pour améliorer la stabilité de longue durée d'un actionneur piézoélectrique (1) enrobé dans un compound (2) dans le cas duquel
- le compound (2) contient ou forme une substance chimique réductrice qui forme des liaisons chimiques avec l'oxygène, en particulier de l'hydrogène, et est contiguë à la surface de l'actionneur piézoélectrique (1),
- l'actionneur piézoélectrique (1) est constitué d'une céramique piézoélectrique contenant de l'oxygène,
- on utilise un compound qui comprend un agent d'adhérence, en particulier du silane,
- et l'agent d'adhérence comprend ou forme la substance réductrice,
- **caractérisé en ce qu'**on utilise des moyens qui compliquent ou arrêtent une interaction entre le compound ou la substance réductrice et l'oxygène de la céramique,
- **en ce qu'**en tant que substance réductrice, on prévoit dans le compound de l'hydrogène,
- et **en ce que** la concentration de l'agent d'adhérence est inférieure à 1 pourcent en poids de sorte que la fréquence de réaction entre l'hydrogène du compound et l'oxygène de la céramique soit réduite.

2. Procédé selon la revendication 1, **caractérisé en ce que** la concentration de la substance réductrice et/ou des partenaires de réaction formant la substance réductrice dans le compound est réduite par l'intermédiaire d'un processus thermique à température élevée.

3. Procédé selon la revendication 2, **caractérisé en ce que** le processus thermique est exécuté de telle façon que la concentration de la substance réductrice, en particulier de l'hydrogène, baisse sous un seuil prédéterminé.

4. Procédé selon l'une des revendications 1 à 3, **caractérisé en ce que** l'actionneur (1) est monté dans un boîtier (14) et **en ce que** le boîtier (14) comprend des moyens (17, 18, 19) pour fournir de l'oxygène au compound (2).

5. Procédé selon l'une des revendications 1 à 4, **caractérisé en ce que** l'actionneur est monté dans un boîtier (14) et **en ce que** le boîtier (14) comprend des moyens (17, 18, 19) pour évacuer la substance réductrice libérée par le compound.

6. Procédé selon l'une des revendications 1 à 5, **caractérisé en ce que** l'actionneur est monté dans un boîtier et **en ce que** le boîtier contient une substance (16) qui est destinée à former des liaisons avec la substance chimique réductrice du compound (2).

7. Actionneur piézoélectrique (1) comprenant une céramique piézoélectrique qui est enrobée dans un compound (2), le compound (2) contenant une substance chimique réductrice qui forme des liaisons avec l'oxygène, en particulier de l'hydrogène, et un agent d'adhérence, **caractérisé en ce que** la concentration de l'agent d'adhérence est inférieure à 1 pourcent en poids.

8. Actionneur piézoélectrique selon la revendication 7, **caractérisé en ce qu'**il est monté dans un boîtier (14) et **en ce que** dans le boîtier est prévue une substance (16) qui réduit la fréquence de réaction entre la substance réductrice et l'oxygène contenu dans la céramique.

9. Actionneur piézoélectrique selon la revendication 7 ou 8, **caractérisé en ce que** le boîtier (14) comprend des moyens (17, 18, 19) pour fournir des substances qui forment des liaisons chimiques avec la substance réductrice du compound (2).

10. Actionneur piézoélectrique selon la revendication 7, 8 ou 9, **caractérisé en ce qu'**il est prévu des moyens (17, 18, 19) pour évacuer la substance réductrice du boîtier (14) et/ou des moyens (17, 18, 19) pour fournir des substances qui forment des liaisons chimiques avec la substance réductrice du compound (2).

11. Actionneur piézoélectrique selon la revendication 9 ou 10, **caractérisé en ce que** les moyens (17, 18, 19) sont réalisés sous la forme d'une membrane dans le boîtier (14) à travers laquelle les substances correspondantes peuvent être évacuées et/ou fournies.
